(19) **Europäisches Patentamt / European Patent Office / Office européen des brevets**

(11) **EP 3 078 031 B1**

(12) **EUROPEAN PATENT SPECIFICATION**

(45) Date of publication and mention
of the grant of the patent:
**30.01.2019 Bulletin 2019/05**

(51) Int Cl.:
*H01B 1/22* (2006.01)     *H01B 1/24* (2006.01)
*H01B 1/04* (2006.01)

(21) Application number: **14806391.0**

(22) Date of filing: **01.12.2014**

(86) International application number:
**PCT/GB2014/053560**

(87) International publication number:
**WO 2015/082890 (11.06.2015 Gazette 2015/23)**

(54) **MANUFACTURING CONDUCTIVE THIN FILMS COMPRISING GRAPHENE AND METAL NANOWIRES**

HERSTELLUNG LEITFÄHIGER DÜNNSCHICHTEN MIT GRAPHEN UND METALLNANODRÄHTEN

FABRICATION DE FILMS MINCES CONDUCTEURS COMPRENANT DU GRAPHÈNE ET NANOFILS MÉTALLIQUES ASSOCIÉS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **02.12.2013 GB 201321244**

(43) Date of publication of application:
**12.10.2016 Bulletin 2016/41**

(73) Proprietor: **M-Solv Ltd**
**Kidlington, Oxford OX5 1FP (GB)**

(72) Inventors:
• **DALTON, Alan Brian**
**Haslemere**
**Surrey GU27 2DR (GB)**
• **JUREWICZ, Izabela**
**Guildford**
**Surrey GU2 7XH (GB)**
• **SATO, Lester Taku**
**Buzzard**
**Bedfordshire LU7 3NT (GB)**

(74) Representative: **J A Kemp**
**14 South Square**
**Gray's Inn**
**London WC1R 5JJ (GB)**

(56) References cited:
**US-A1- 2012 070 612     US-A1- 2013 078 449**
**US-A1- 2013 255 763**

## Description

The present invention relates to methods and apparatus for manufacturing a conductive thin film that has high performance in terms of its optical and electrical properties, and low cost. The invention relates in particular to films that are also transparent.

Indium tin oxide (ITO) is one of the most used materials in applications where there is a need for transparent and conductive thin films due to its low sheet resistance, $R_s$, ($R_s$ < 100 Ω/sq), and high optical transmittance ($T$ > 90%). However, ITO suffers from several important drawbacks, such as high cost, brittleness, and a requirement for high processing temperatures.

As an alternative, carbon nanotubes (CNTs) and graphene have recently been used successfully in several applications, including Light Emitting Diodes (LED), solar cells, sensors, and transparent electrodes. Although these materials show great potential and are possibly a low-cost solution for the applications mentioned, they have not yet achieved sheet resistance and transmittance comparable to ITO.

Silver nanowires (AgNWs) are another potential candidate to replace ITO. High electrical and thermal conductivities, as well as excellent optical transmittance of AgNW networks make them one of the most promising materials to be used as transparent electrodes in optoelectronic applications. Many groups have reported using AgNWs to produce flexible, transparent, and conducting thin films. Polymer substrates coated with thin films of AgNW are available commercially from various suppliers eg Toray, Carestream, Okura and Hitachi Chemical.

There are many techniques available to fabricate thin films of AgNWs on substrates, such as vacuum filtration, Langmuir-Blodgett (LB), drop casting, Meyer-rod-coating and spray deposition.

De and co-workers have produced AgNW thin films by vacuum filtering aqueous dispersions of AgNWs onto a cellulose membrane, achieving a transmittance, $T$, of 85% and a $R_s$ of 13 Ω/sq. (van de Groep, J., P. Spinelli, and A. Polman, Transparent Conducting Silver Nanowire Networks. Nano Letters, 2012. 12(6): p. 3138-3144). Hu et al. have reported the use of the Meyer rod coating technique to produce AgNW thin films with $T$ = 80% and $R_s$ = 20 Ω/sq (Hu, L., et al., Scalable Coating and Properties of Transparent, Flexible, Silver Nanowire Electrodes. ACS Nano, 2010. 4: p. 2955 - 2963). Scardaci et al. have reported large-scale deposition of AgNWs with spray coating. They showed $T$ = 90% and $R_s$ = 50 Ω/sq for their deposited films (Scardaci, V., et al., Spray Deposition of Highly Transparent, Low-Resistance Networks of Silver Nanowires over Large Areas. Small, 2011. 7(18): p. 2621-2628, Scardaci, V., R. Coull, and J.N. Coleman. Spray deposition of Silver Nanowire transparent conductive networks. in Nanotechnology (IEEE-NANO), 2012 12th IEEE Conference on. 2012).

Although AgNW networks demonstrate comparable electrical conductivity and optical transmittance to ITO thin films, some challenges remain. For example, it would be desirable to reduce wire junction resistance and/or eliminate parasitic lateral current flow, which is due to gaps between silver nanowires. Moreover, mechanical robustness and flexibility of the AgNW thin films is limited. Additionally, AgNWs are currently very expensive (~ $5/mg) and their adhesion to most substrates is poor. Another disadvantage relates to issues with chemical stability. AgNWs can easily oxidize by exposure to air and water for an extended period of time, which results in a marked increase in the $R_s$ and increased haze of the film.

It is known that heat treatment can be used to reduce junction resistance between wires and consequently achieve high electrical conductivity. However, such temperature treatment is likely to damage certain substrates. Heat treatment may also represent a relatively expensive post-fabrication process.

While numerous studies have investigated AgNWs and graphene individually as transparent conductors, little research has been done on the hybrid systems of AgNWs/graphene. Yun et al. (Yun, Y.S., et al., Transparent conducting films based on graphene oxide/silver nanowire hybrids with high flexibility. Synthetic Metals, 2012. 162(15-16): p. 1364-1368) have made a layered system of AgNW networks and graphene oxide (GO) to make a flexible thin film with a transmittance of 86% and a sheet resistance of 150 Ω/sq, by thermal annealing at 150°C. Zhang et al. have fabricated AgNW films coated with a GO layer by spin-coating (Xinfeng, Z., W.N.M. Wong, and M.M.F. Yuen. Conductive, transparent, flexible electrode from silver nanowire thin film with double layer structure. in Nanotechnology (IEEE-NANO), 2012 12th IEEE Conference on. 2012). They have shown that both the electrical conductivity and the chemical stability of AgNW were enhanced after being coated with a GO layer. Their GO-coated NW film remained stable upon heating to temperatures up to 275°C. Another hybrid system was made by Kholmanov et al. (Kholmanov, I.N., et al., Improved Electrical Conductivity of Graphene Films Integrated with Metal Nanowires. Nano Letters, 2012. 12(11): p. 5679-5683), with a goal of minimizing the influence of the line defects and the line disruptions of graphene grown by CVD. Subsequently, a hybrid system has been made by spin coating AgNW dispersions from isopropyl alcohol on the graphene film. They obtained a $R_s$ of 64 ± 6.1 Ω/sq and $T$ of 93.6%. This experiment employed high quality graphene which is expensive to produce and is hardly scalable using traditional CVD processes. In another study, Ahn et al. (Ahn, Y, Y. Jeong, and Y. Lee, Improved Thermal Oxidation Stability of Solution-Processable Silver Nanowire Transparent Electrode by Reduced Graphene Oxide. ACS Applied Materials & Interfaces, 2012. 4(12): p. 6410-6414) prepared an AgNW/graphene hybrid transparent electrode by dip-coating reduced graphene oxide onto the AgNW film. Chen et al. (Chen, R., et al., Co-Percolating Graphene-Wrapped Silver Nanowire Network for High Performance, Highly Stable, Transparent Conducting Electrodes. Advanced Functional Materials, 2013) have shown a hybrid system of CVD grown graphene intimately wrapped around AgNWs by depositing both on the bottom and top sides of the network. In their study they were successful in reducing the graphene $R_s$ from 770 to 22 $\Omega$/sq with $T$ about 88%. They have also demonstrated that hybrid films with graphene on the bottom of AgNWs networks is not effective and moreover that markedly low $R_s$ is achievable in an inverted structure, where the graphene is on top of the AgNW network. All the above studies suggest that there is potential for using hybrid systems of nanowires and graphene to produce functional hybrid structures. However, in each case there are fundamental limitations. Most of the work has relied on graphene grown by CVD. This is an expensive process that requires high temperature growth followed by complicated post processing. Moreover, as of today, there are major issues in the realisation of CVD as an up scalable process to produce high quality graphene in commercially viable quantities.

US 2013/255763 A1 discloses a method of producing a carbon electrode comprising treating a graphene oxide with hydrazine and electrochemically reducing the hydrazine-treated graphene oxide in a supporting electrolyte solution. The hydrazine-treated graphene oxide is electrochemically reduced on a conductive film containing a metal nanowire.

US 2012/0070612 A1 discloses a method of manufacturing a graphene-polymer layered composite. Electrical conductivity of the composite may be enhanced by forming nanostructures on the graphene sheet, such as a nanowire or nanostructures having surfaces on which metal particles are formed.

It is an object of the invention to provide methods and apparatus that allow for improved manufacture of conductive thin films, at least partially addressing one or more of the problems with the prior art discussed above.

The scope of the invention is defined in the appended claims.

The inventors have found that solution processed graphene provides individual sheets of graphene that locate themselves preferentially at junctions between wires of the nanowire layer and engage therewith in such a way as to provide a surprisingly large decrease in sheet resistance, even with relatively small amounts of graphene. The decrease in sheet resistance is particularly marked where the nanowire layer is a low density layer, for example a monolayer and/or a layer that is in the percolative regime. The decrease in resistance is also particularly marked where the layer of graphene is deposited after the layer of the nanowires, because the sheets of graphene fall into the nanowire structure and engage effectively with the junctions. A similar effect can also be achieved by depositing the graphene onto a surface having a microstructure than causes the individual graphene sheets to be pushed up into the nanowire layer when the nanowire layer is formed on top of graphene layer.

Resistivities that are adequate for conductive thin film applications (such as touch screen displays, batteries and fuel cells) can be achieved using less nanowire material than in alternative prior art methods. This reduces cost. In the case of touch screen displays (and other applications where transparency is desirable), the use of less material in the thin film layer also advantageously facilitates higher transmittance.

The inventors have also found that the improved electrical properties provided by the graphene sheets is also robust against mechanical deflection or distortion of the thin film, thus improving reliability and/or increasing the range of situations in which the thin films can be used. The robustness against mechanical deflection or distortion arises because where a sheet of graphene provides bridging between different wires, the bridging can be maintained as the wires move relative to each other because of the possibility of the wires making a sliding contact with the graphene sheets. In alternative prior art techniques, for example those involving welding at junctions between different wires, movement of the wires can break the bridging and lead to much larger increases in resistance (and associated impairment of device function).

In an embodiment, the substrate is provided with a microstructure that encourages the graphene to be pushed into the nanowire layer. This enables the graphene layer to improve the properties of the nanowire layer most effectively, especially where the graphene layer is formed on the substrate before the nanowire layer.

In an embodiment, a heat treatment is provided to the layer of metal nanowires to cause sintering of the layer of metal nanowires. In an embodiment, the layer of metal nanowires is formed on the substrate before the layer of solution processed graphene and the heat treatment causing sintering is applied before formation of the layer of solution processed graphene. In an alternative embodiment, the layer of solution processed graphene is formed on the substrate before the layer of metal nanowires and the heat treatment causing sintering is applied after formation of the layer of metal nanowires. The inventors have found that both of these approaches can provide a reduction in sheet resistivity.

In an embodiment, the composite layer (e.g. the layer of solution processed graphene and the layer of metal nanowires, without the substrate) has a visible light transmittance of at least 40%, preferably at least 80%, preferably at least 90%. In certain embodiments the visible light transmittance may be arranged to be 95% or even 98%. The composition of the composite layer makes it possible to achieve such light transmittances while still maintaining a very low sheet resistance.

Embodiments of the invention will now be described, by way of example only, with reference to the accompanying drawings in which corresponding reference symbols indicate corresponding parts, and in which:

Figure 1 depicts a substrate with a layer of nanowires formed thereon;

Figure 2 depicts the substrate of Figure 1 after a layer of solution processed graphene has been formed on the layer of nanowires;

Figure 3 depicts a substrate with a layer of nanowires formed thereon being moved towards a bath of liquid having a layer of graphene formed at an interface on the liquid.

Figure 4 depicts the substrate of Figure 3 after a layer of graphene has been formed on the layer of nanowires by bringing the layer of nanowires into contact with the layer of graphene at the interface of the liquid in the bath:

Figure 5 depicts an alternative arrangement for transferring graphene formed at an interface of a liquid in a bath onto a substrate, in which the substrate is moved while oriented perpendicularly relative to the interface of the liquid:

Figure 6 depicts an alternative arrangement for transferring graphene formed at an interface of a liquid in a bath onto a substrate, in which the substrate is flexible and is conveyed onto the interface at the surface of the liquid using a roller;

Figure 7 depicts SEM micrographs of low (a), medium (b) and high (c) density AgNW layers that have been spray-deposited on glass substrates. Low density corresponds to MΩ/sq sheet resistance, medium density corresponds to kΩ/sq sheet resistance and high density corresponds to Ω/sq sheet resistance;

Figure 8 depicts (a) AFM height image and (b) SEM micrograph of graphene-wrapped silver nanowire junctions;

Figure 9 depicts mean optical transmittance, $T$, plotted as a function of sheet resistance, $R_s$, for different nanowire layers;

Figure 10 depicts (a) AFM topography and (b) c-AFM surface conductivity map of a very low density pristine AgNW layer showing no flow of current through a wire that is not connected to the network, and (c) AFM topography and (d) c-AFM surface conductivity map of a AgNW/graphene hybrid;

Figure 11 depicts optical transmittance versus sheet resistance for (■) pristine AgNW networks and (▲) AgNW networks containing graphene flakes at the junctions. Inset: current-voltage (I-V) characteristics of pristine AgNW networks (30) and after graphene deposition (32);

Figure 12 depicts the variation of conductivity as a function of concentration for a nanowire layer in in and around the percolative regime.

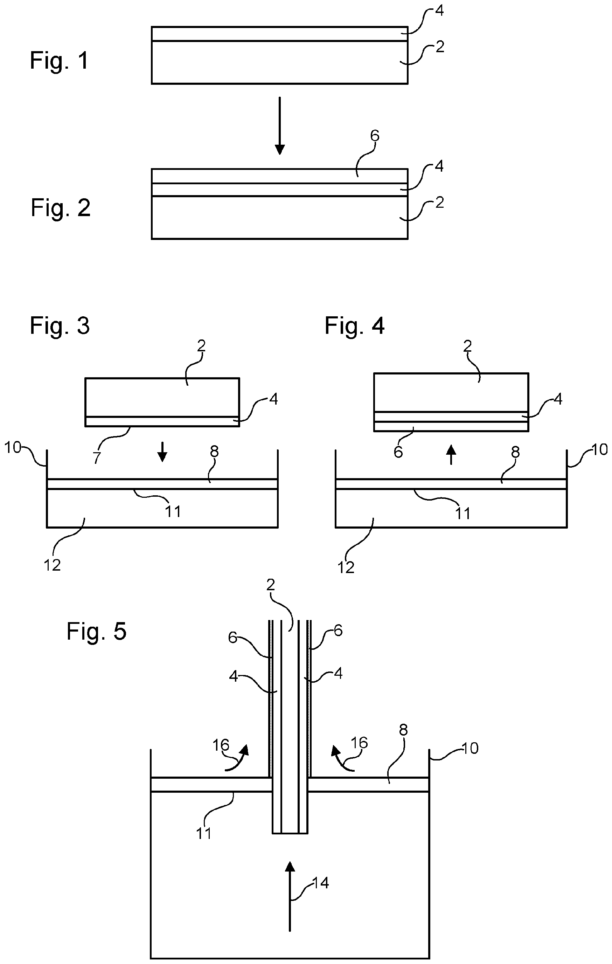

Figures 1 and 2 illustrate schematically steps in a method of manufacturing a conductive thin film according to an embodiment. The method involves forming a composite layer on a substrate 2. The composite layer comprises a layer 6 of solution processed graphene directly adjacent to a layer 4 of metal nanowires. For example, the graphene layer 6 may be adjacent to the nanowire layer 4 with no other layer in between the two layers. The graphene layer 6 may also partially extend into the nanowire layer 4. Neither the graphene layer 6 nor the nanowire layer 4 needs to be continuous. Indeed, when viewed from a direction perpendicular to each layer 4, 6, it is expected that there will be many gaps in each layer. In the case of the graphene layer 6, there may be gaps in between individual graphene sheets. In the case of the nanowire layer, there may be gaps in between individual wires.

The substrate may be transparent, for example where the thin film is to be used to implement a touch screen display. Alternatively, the substrate may be opaque, which may be acceptable where the thin film is to be used in batteries or fuel cells, for example.

Solution processed graphene is known in the art and comprises a plurality of individual sheets of graphene stabilized in a liquid. Typically, a majority or all of the individual sheets have a longest dimension in the range of 1 nanometre to 100 micrometer, optionally between 20 nanometres and 50 micrometres.

In an embodiment the layer of solution processed graphene is formed from a non-percolative distribution of the individual sheets. In other words the size, shape and quantity of the individual sheets is such that a percolative network is not established through the individual sheets themselves. The amount of graphene needed is thus less than in alternative arrangements where a percolative network of graphene is provided. Less graphene promotes improved transmittance. The inventors have recognised that the cooperation between the individual sheets of graphene and the layer of metal nanowires can achieve sufficiently low sheet resistances even in the absence of a percolative network of individual sheets.

The metal nanowires may be formed from one or more of a range of different metals, including one or more of the following: Ag, Au, Pt, Cu, Pd, Ti, Al, Li.

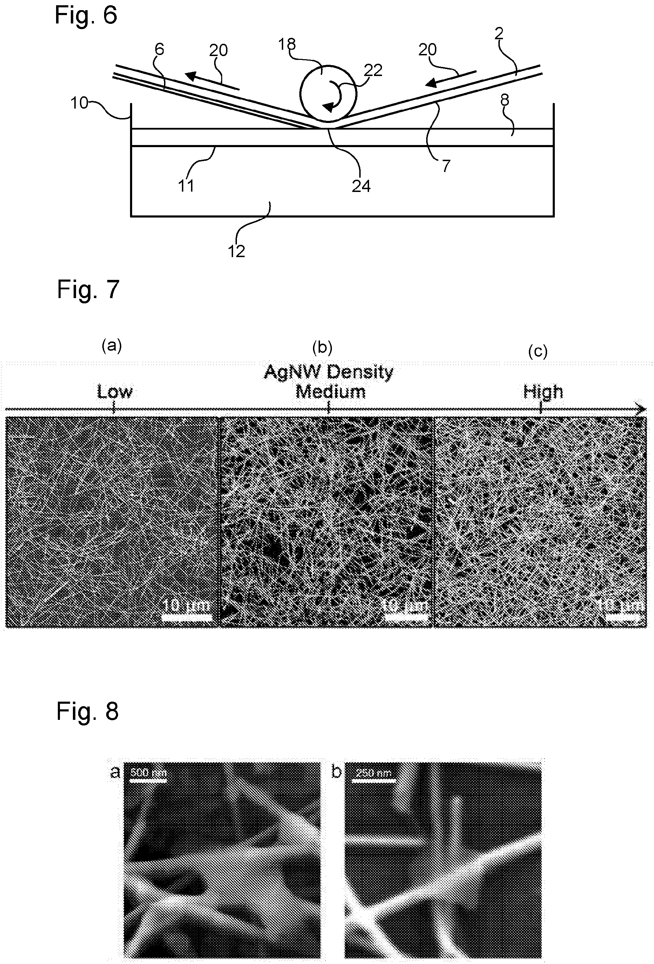

In an embodiment, the nanowire layer 4 is formed on the substrate 2 before the graphene layer 6. This is the case in the example method shown in Figures 1 and 2. Figure 1 depicts a substrate 2 after the nanowire layer 4 has been formed. Figure 2 depicts the substrate 2 after subsequent formation of the graphene layer 6 on the nanowire layer 4. The combination of the graphene layer 6 and the nanowire layer 4 may be referred to as a "composite layer". Depositing the graphene onto the nanowires results in individual sheets of the graphene layer 6 penetrating partially into the nanowire layer 4 and improving (reducing) the resistance of the nanowire layer by engaging effectively (e.g. by "wrapping around") junctions between different nanowires. Figures 8(a) and 8(b) show AFM height image and SEM micrograph data showing graphene-wrapped AgNW junctions.

In other embodiments the graphene layer 6 is formed on the substrate 2 before the nanowire layer 4. In this case, it is preferable that a surface of the substrate onto which the graphene layer 6 is to be formed comprises a microstructure that is effective to press or force individual sheets of the graphene into the nanowire layer 6. The inventors have found that this approach allows individual sheets of the graphene to wrap around junctions between different wires in the nanowire layer 6 and decrease the resistance thereof, thereby allowing the nanowire layer 4 to be applied at a lower surface area density, thus improving transmittance and reducing cost.

In an embodiment, the microstructure has a characteristic length scale that is within a factor of 10 (preferably a factor of 5, more preferably a factor of 2) of the average separation between junctions between different wires. The characteristic length scale of the microstructure may be a dominant spatial frequency or periodicity for example. For example, where the microstructure is formed from repeating units, the characteristic length scale may be equal to the period of the repeating units.

In an embodiment the nanowire layer is provided at a low enough surface area density that the interaction with the graphene layer 6 (whether formed before or after the nanowire layer 4) leads to a significant reduction in the resistivity.

In an embodiment, for example, the nanowire layer 4 is formed as a monolayer. In prior art approaches, a monolayer would generally not be sufficient to create adequate conductivity. However, the graphene layer 6 based on solution processed graphene makes it possible to achieve appropriate resistivities.

In an embodiment, the nanowire layer 4 is formed at a density that causes the optical and/or electrical properties of the film to exhibit percolative behaviour to a greater extent than bulk behaviour. The nanowire layer 4 thus formed may be a monolayer. The solution processed graphene is particularly effective at reducing resistivity when the nanowire layer is in the percolative regime because the graphene sheets can provide bridging between different nanowires, thus increasing the number of paths by which the electrical current can pass along the layer. Additionally, the role of junction resistance, which the individual graphene sheets applied according to embodiments are particularly effective at reducing, is greater for layers in the percolative regime in comparison with thicker layers.

A characteristic feature of the percolative regime is that the following power law relationship is satisfied between the conductivity of the layer and the concentration of the nanowires within the layer:

$$\sigma = \sigma_0 (\phi - \phi_c)^t \text{ for } \phi > \phi_c$$

where $\sigma$ is the conductivity of the nanowire layer (S/cm), $\sigma_0$ is a proportionality constant, and $\phi$ is the concentration of nanowires in the layer, $\phi_c$ is the critical concentration marking the lower bound of the percolative behaviour, and $t$ is a power law exponent in the range of 1-1.33.

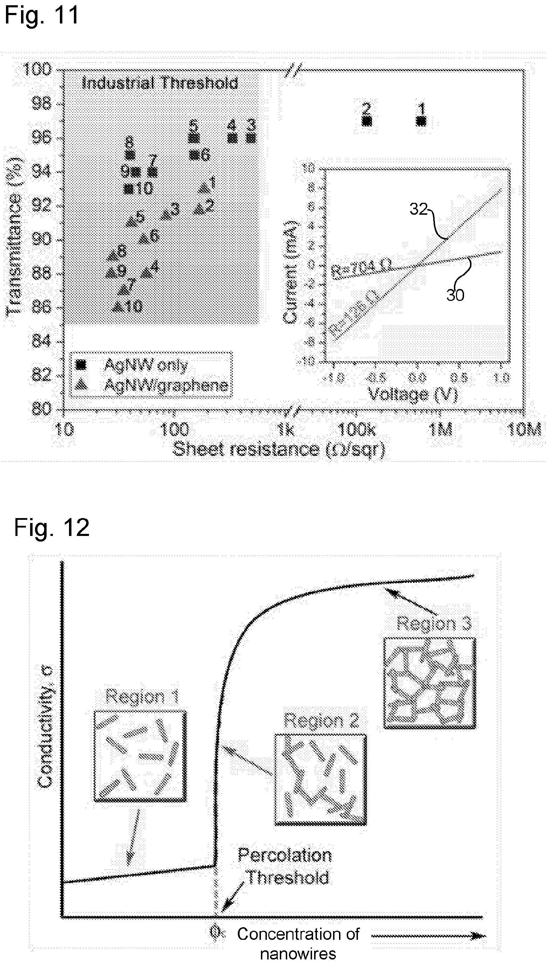

The behaviour of percolative networks can be described using percolation theory (Stauffer, D., Introduction to percolation theory. Taylor & Francis: London; Philadelphia, 1985, Kulshreshtha, A. K.; Vasile, C., Handbook of polymer blends and composites. Rapra Technology Lt.: Shawbury, Shewsbury, Shropshire, [England], 2002). Figure 12 is a schematic illustration, based on this theory, showing the expected variation in conductivity as a function of nanowire concentration. As can be seen, below a critical concentration of the nanowires ($\phi_c$), the overall conductivity approaches zero (Region 1 in Figure 12), with individual wires largely disconnected from each other (see inset). At a critical concentration of the nanowires, $\phi_c$, an insulator-conductor transition takes place, marking the point at which continuous paths start to be formed along lines of nanowires. In a narrow regime just beyond $\phi_c$ the conductivity rises very quickly as the continuous networks are formed (Region 2 in Figure 12; see inset). At higher concentrations, once a conductive network has been fully formed (Region 3 in Figure 12 and associated insert), the rate of rise of conductivity is more moderate or even approaches zero as the effect of each additional nanowire on the conductivity falls.

In a specific example in which the metal nanowires are AgNWs, the nanowires are provided at a density which causes the sheet resistance $R_s$ of the metal nanowires, in the absence of any graphene, to be equal to or greater than 100 $\Omega$/sq, preferably equal to or greater than $10^3$ $\Omega$/sq, preferably equal to or greater than $10^4$ $\Omega$/sq, preferably equal to or greater than $10^5$ $\Omega$/sq, preferably equal to or greater than $10^6$ $\Omega$/sq, preferably equal to or greater than $10^7$ $\Omega$/sq, preferably equal to or greater than $10^8$ $\Omega$/sq, preferably equal to or greater than $10^9$ $\Omega$/sq, preferably equal to or greater than $10^{10}$ $\Omega$/sq, preferably equal to or greater than $10^{11}$ $\Omega$/sq, preferably equal to or greater than $10^{12}$ $\Omega$/sq. Embodiments of the invention may also be applied where the sheet resistance takes lower values, for example lower than 100 $\Omega$/sq. This may be particularly applicable where the primary aim of adding the graphene is to make the resulting thin film more flexible or stretchable (without changing its sheet resistance to severely). In this case, the graphene may be of interest even if the effect of the graphene on the sheet resistance is not large.

In an embodiment, a capillary pressure driven mechanism is used to transfer graphene onto the surface of the substrate 2 or nanowire layer 4. One approach of this type is illustrated schematically in Figures 3 and 4. Here, a bath 10 containing a liquid 12 is provided. Processing has been carried out according to known prior art techniques to provide a layer of graphene 8 at an upper interface 11 of the liquid 12. The substrate 2, with or without a nanowire layer 4 thereon (Figures 3 and 4 show an example with the nanowire layer 4 present), is then lowered (Figure 2) until the surface 7 onto which the graphene layer 6 is to be formed is brought into contact with the graphene 8 at the liquid interface 11. Capillary pressure then causes transfer of graphene from the interface 11 onto the surface 7 and the graphene layer 6 is formed. The substrate 2 can then be moved away from the bath 10 (Figure 3). This particular geometry for transferring graphene onto a surface using capillary pressure corresponds to the so-called Longmuir-Schaefer (LS) process known in the prior art.

Figure 5 depicts an alternative arrangement in which the substrate 2 is pulled out of the bath 10 while being oriented in a substantially perpendicular direction (see arrow 14) relative to the liquid interface 11. Graphene is then transferred (see arrows 16) by capillary pressure from the layer of graphene 8 on the surface of the liquid 12 in the bath 10 onto the substrate 2. This particular geometry for transferring graphene onto a surface using capillary pressure corresponds to the so-called Longmuir-Blodgett (LB) process known in the prior art. In this particular example the nanowire layer 4 is already present on the substrate 2 so the graphene layer 6 is formed on the nanowire layer 4. However, in other embodiments, the graphene layer 6 may be formed directly on the substrate 2 and the nanowire layer 4 may be formed, in a later step, on top of the graphene layer 6.

In the example shown in Figure 5, the substrate 2 has nanowire layers 4 formed on both sides of the substrate 2 and the graphene layer 6 is formed on both sides of the substrate 2. This approach is convenient because of the geometry of this particular embodiment. If only a single composite layer is required the substrate can be cut in a later step to separate the two composite layers formed on opposite sides of the substrate 2. Alternatively, the substrate 2 may be arranged so that graphene is only picked up on one side and/or graphene picked up on one of the sides may be discarded.

In an alternative embodiment, a surface on which the layer of graphene is to be formed is conveyed so as to be brought into a line contact 24 with the graphene 8 (without any part of the surface, at least in the region immediately adjacent to the line contact 24, being in contact with the graphene and/or without any part of the substrate being submerged within the liquid) at the liquid interface 11 while moving relative to the graphene 8 in a direction perpendicular to the line 24. In such an embodiment, the substrate may be conveyed over the surface in such a way that the portion of the substrate that is in contact with the layer of graphene 8 (i.e. at the line contact 24) moves in a direction that is substantially parallel to a plane within which a majority of the layer of graphene 8 lies. At positions away from the line contact the substrate may be moving in directions that a not parallel to the plane. An example of an embodiment of this type is depicted in Figure 6. Here, arrows 20 illustrate movement of the substrate 2 (and, therefore, the surface 7 on which the graphene is to be formed) relative to the line contact 24 (extending into the page) with the graphene 8 at the interface. As the substrate 2 passes the line contact 24 graphene is transferred onto the surface 7 by capillary pressure in order to form the graphene layer 6. In the particular example shown a roller 22 is provided to convey the substrate 2 in the necessary way. This arrangement is desirable for volume production because the substrate size is not limited by the size of the bath 10. Graphene can be added continuously to the bath (in this and in other embodiments) at an appropriate rate to ensure that graphene is consistently available for transfer to the surface at the line contact 24.

In an embodiment, the layer of graphene at the liquid interface is provided so as to have a surface pressure of less than 25 $mNm^{-1}$, preferably less than 5 $mNm^{-1}$. In this way a surface pressure that is adequate to reduce the resistivity of the nanowire layer 4 by the desired extent is provided whilst not excessively reducing the optical transmittance $T$ through the composite film.

In an embodiment, the layer of graphene 8 at the liquid interface 11 is subjected to one or more compression and expansion cycles by respectively decreasing and increasing the surface area available for the layer of graphene 8 at the liquid interface 11. For example one or more moveable barriers may be provided that can be moved across the surface of the liquid 11 in order to change the surface area available for the layer of graphene 8. Decreasing the area available compresses the layer of graphene 8 and increasing the area expands the layer of graphene 8. The compression and expansion cycles act to distribute individual sheets of graphene in the graphene layer more uniformly across the layer of graphene 8. This leads to a more uniform distribution of the graphene sheets in the graphene layer 6 formed on the substrate 2 and allows the same degree of resistance reduction to be achieved using a smaller amount of graphene, thus reducing the amount of graphene that is required and improving the transmittance $T$ of the final composite layer.

Alternatively or additionally, the forming of the graphene layer 6 comprises spraying of the graphene onto the surface 7. Alternatively or additionally, the forming of the graphene layer 6 comprises slot die coating. Various methods may be used for forming the nanowire layer 4, including for example spraying.

In an embodiment, a heat treatment is provided to the layer of metal nanowires to cause sintering of the layer of metal nanowires. In an embodiment, the layer of metal nanowires is formed on the substrate before the layer of solution processed graphene and the heat treatment causing sintering is applied before formation of the layer of solution processed graphene. In an alternative embodiment, the layer of solution processed graphene is formed on the substrate before the layer of metal nanowires and the heat treatment causing sintering is applied after formation of the layer of metal nanowires. Various temperatures and times can be used to achieve effective sintering. In one example the inventors found that heating at about 110 degrees C for 20 minutes was effective.

In an embodiment, the composite layer (e.g. the layer of solution processed graphene and the layer of metal nanowires, without the substrate) has a visible light transmittance of at least 40%, preferably at least 80%, preferably at least 90%. In certain embodiments the visible light transmittance may be arranged to be 95% or even 98%.

## Examples

Detailed non-limiting examples and supporting/explanatory experiments are discussed below.

Silver nanowires in isopropyl alcohol were purchased from Seashell Technologies (www.seashelltech.com). A small volume of the dispersion was diluted down to 0.25 mg/mL with di-water and subjected to half an hour low bath sonication (Fisher Scientific FB15051) using sweep mode under chilled conditions. The average diameter and length of the nanowires were measured to be 60 nm and 10 $\mu$m respectively. Films were formed by spraying the diluted dispersion onto a glass substrate 2 using an airbrush. The dispersion was atomized into very small droplets using pressurized air to create a velocity gradient as the liquid is passed through the nozzle of an airbrush. The "back pressure" driving the flow of air directs the droplets onto the substrate 2 below. Keeping the nozzle to substrate distance constant, the airbrush spray is moved in a set pattern with respect to the substrate 2. This pattern is repeated several times until the required network thickness is achieved. The film thickness (and so transparency) can be controlled by tuning sprayed volume (through the number of repeated sprayed patterns) and concentration of the solution.

The graphene dispersion was prepared as described elsewhere. Briefly, as-produced sieved graphite powder (Aldrich product 332461, batch number 06106DE) was added to N-methylpyrrolidone (NMP) (spectrophotometric grade, 99.0%) to give an initial graphitic concentration of 0.1 mg/ml and sonicated using low power bath sonication (Model Ney Ultrasonic) for 30 minutes. The resulting dispersion was then centrifuged using Hettich Mikro 22R centrifuge for 90 minutes at 500 rpm. 1 mL of the resulting NMP dispersion was mixed with 100 mL of chloroform and sonicated using bath sonicator (fisher scientific FB15051) for 60 minutes, followed by centrifugation (Eppendorf 5702) for 90 minutes at 4000 rpm. The supernatant was then bath sonicated under chilled conditions for a further 30 minutes. The final dispersed graphene concentration in NMP/chloroform mixture was calculated to be ~0.007 mg/ml (as determined by UV-Vis spectrophotometer).

In this example, graphene was deposited onto the substrate 2 using the so-called Langmuir-Schaefer (LS) process (see for example Fahimi et al. Carbon 2013 DOI: /10.1016/j.carbon.2013.07.096). In this example, a commercial NIMA deposition trough (NIMA technology, model 612D) was used. The graphene dispersion in chloroform/NMP mixture prepared as described above was spread onto the water subphase drop-by-drop. The volume of the material deposited was ranging from 2 mL to 10 mL depending on the density of graphene layer that needed to be deposited. The pressure-area isotherms were obtained after 10 min waiting time to let the remaining solvent evaporate at the barrier compression speed of 15 cm$^2$/min. Graphene was then transferred onto silver nanowire networks by LS horizontal deposition technique at various surface pressures (ranging from 0 to 40mNm$^{-1}$) using a transfer speed of 3 mm/min.

The spray deposition of AgNW requires careful optimization of the process and involves controlling the concentration of AgNWs in the dispersion, spray deposition pressure, flow rate, scan speed, distance from the substrate, and substrate temperature. AgNW in IPA dispersions were used and sprayed down with the same method as described in the previous section, with three different densities (low, medium and high). In order to make a AgNW conductive network, wires have to form a continuous percolating network and large scale aggregation needs to be avoided. This can be controlled not only by the number of spray repetitions but also by the solution concentration. Here the desired network density (low, medium and high) was achieved by a variation in the number of layers of NWs.

Figure 7(a) shows a SEM of a low density AgNW layer (high 7), obtained by two layer deposition. Figure 7(b) shows a AgNW layer obtained by 3 to 4 layer deposition. Figure 7(c) shows a AgNW layer obtained by more than 5 layers, resulting in low T. The insulating glass substrates appear as black areas due to charging and low secondary electron emission from these regions, and the conductive NW networks correspondingly appear white. As the film thickness was increased, networks became denser, and as a result the substrate is less visible in the micrographs. It is evident that the uniformity of network improves with increasing density of the AgNW network.

The relationship between the optical and electrical properties of the resulting networks can be analysed in terms of two regimes, namely the percolative and bulk-like regimes.

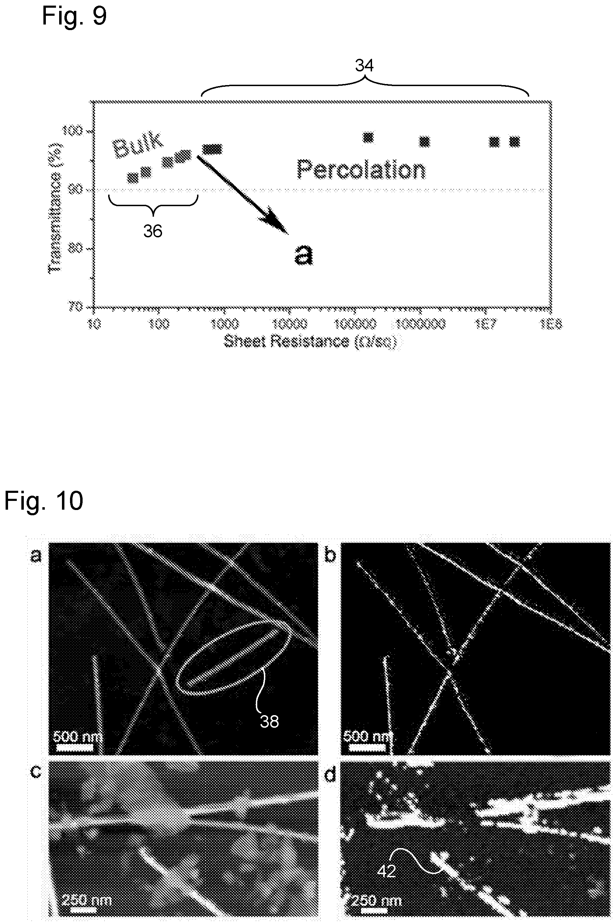

Measurements for the present example of transmittance $T$ versus sheet resistance $R_s$ (see Figure 9) show percolative and bulk-like regimes as expected. The crossover between these regimes occurs for nanowire layers with $T$ = 93%. In the region designated 34 in Figure 9 the nanowires form a monolayer percolated network. In the regime designated by 36 in Figure 9 the conductivity is dominated by bulk-like transport. At point "a", although the conductivity mechanism is transitioning into the bulk regime the transmittance is still above 90% making the films viable as electrodes.

Lee at el. estimated junction resistances of about 1$\Omega$ for AgNWs with diameters less than 0.3 $\mu$m$^{-2}$, using computer generated random meshes, and about 40 $\Omega$ for diameters larger than 0.3 $\mu$m$^{-2}$ (Lee, J., et al.,

Solution-processed metal nanowire mesh transparent electrodes. Nano Lett, 2008. 8: p. 689 - 692). Hence, the formation of many parallel connections with the lowest resistance connections dominates the macroscopic resistance. In order to develop highly conducting AgNW films, it is critical to understand the electrical properties of junctions. To measure the junction resistances, as well as to check if the current flow exists out of plane as well as through it, the inventors performed conductive AFM (c-AFM) measurements.

The main advantage of c-AFM over other methods such as STM is the ability to correlate electrical transport properties with topography. The basic principle of c-AFM technique is similar to AFM contact mode. In c-AFM a metal-coated AFM tip acts as one electrode and a conductive substrate or a metal electrode on the surface of a substrate is used as the second electrode. In principle, the measurement can be applied in two different configurations. In both configurations, the first electrode is the conductive AFM tip and acts as a movable electrode. The first configuration, which we will call the horizontal configuration, involves the film of interest to be deposited on an insulated substrate. Here the measurement is performed by applying a constant voltage between the tip and metal electrode and as a result measuring the generated current flow. The local I-V characteristic can then be collected by sweeping the voltage between the tip and the electrode. As each measurement can be effectively pixelated with the current being measured at each point the measurement results in a map of electrical characteristics as a function of x and y (directions within the plane of the nanowire layer 4 being considered). The second method is set up in a vertical configuration regime. In this configuration the samples were deposited on a conductive substrate which acts as the second electrode.

The inventors used horizontal c-AFM to probe the local electron transport in AgNW layers. Figure 10(a) and 10(b) respectively show AFM topography and c-AFM measurements for typical images produced for a low-density AgNW layer. Here, single pass measurements have been used whereby both AFM topographical and c-AFM images are obtained directly and so one can easily overlap and confirm that they are from the same nanowire layers. It can be seen that as the vast majority of the wires are connected to the network, there is direct overlap between the images in (a) and (b) except for a few minor differences. However, in a region where a nanowire (within the region marked 38) has been deposited in such a way as to be isolated from all other nanowires in the layer, it shows up in the topography image but is not present in the c-AFM image. This is as expected as the isolated wire will not contribute to the conductivity through the network formed by the other wires if it is not connected to any of them. As we can effectively measure and quantify the electrical properties on specific points of individual nanowires it is possible to look at the change in resistance not only along the nanowire length but more importantly as one transitions across a junction.

Figures 10(c) and 10(d) respectively show AFM topography and c-AFM measurements for the same regions of a nanowire layer as those shown in Figures 10(a) and 10(b), but after treatment to deposit graphene onto the nanowire layer. The graphene sheets 40 can be seen most clearly in the AFM topography measurements (Figure 10(c)). It can be seen that the graphene sheets act as a bridge between the isolated wire and the remaining wires and result in the wire being electrically connected to the rest of the network. In contrast to the situation in Figure 10(b), therefore, the isolated wire (marked as 42) can clearly be seen in the c-AFM measurement of Figure 10(d) because it can now contribute to the conductivity.

Figure 11 shows the relationship between the optical transmission, $T$, and sheet resistance, $R_s$, for ten different nanowire layers before (squares) and after (triangles) LS deposition of graphene. The figure shows that the hybrid films (comprising the composite layer of nanowires and graphene) follow the same percolation regime as the pure AgNW layers. It can also be seen that depositing graphene on AgNW layers creates a strong shift toward lower resistance. There is a shift towards lower resistance for all the samples, but the shift is particularly strong for samples that are highly transmissive (see samples 1, 2 and 3 for example).

**Claims**

1. A method of manufacturing a conductive thin film, comprising:

   forming a composite layer on a substrate (2), the composite layer comprising a layer of solution processed graphene (6) directly adjacent to a layer of metal nanowires (4), **characterised in that**:

   the forming of the layer of graphene (6) comprises spraying of the graphene onto a surface on which the layer is to be formed.

2. A method according to claim 1, wherein the layer of metal nanowires (4) is a monolayer.

3. A method according to claim 1 or 2, wherein the composite layer has a visible light transmittance of at least 40%.

4. A method according to any of the preceding claims, wherein the layer of metal nanowires (4) is formed on the substrate (2) before the layer of solution processed graphene (6), and the method comprises applying a heat treatment to the layer of metal nanowires (4) to cause sintering between the metal nanowires, before formation of the layer of solution processed graphene (6).

**5.** A method according to any of claims 1-3, wherein the layer of solution processed graphene (6) is formed on the substrate (2) before the layer of metal nanowires (4).

**6.** A method according to claim 5, further comprising:

applying a heat treatment to the layer of metal nanowires (4) to cause sintering between the metal nanowires, after formation of the layer of metal nanowires (4).

**7.** A method according to claim 5, wherein the substrate (2) is provided with a surface microstructure that is effective to press sheets of the solution processed graphene into the layer of metal nanowires (4) in order to cause wrapping of the sheets around junctions between different nanowires.

**8.** A method according to claim 7, wherein the microstructure has a characteristic length scale that is within a factor of 10 of the average separation between junctions between different wires.

**9.** A method according to any of the preceding claims, wherein the metal nanowire layer (4) is deposited at a density that causes the optical and/or electrical properties of the film to exhibit percolative behaviour to a greater extent than bulk behaviour, wherein percolative behaviour is **characterized by** satisfaction of the following power law:

$$\sigma = \sigma_0(\phi - \phi_c)^t \text{ for } \phi > \phi_c$$

where $\sigma$ is the conductivity of the nanowire layer (S/cm), $\sigma_0$ is a proportionality constant, and $\phi$ is the concentration of nanowires in the layer, $\phi_c$ is the critical concentration marking the lower bound of the percolative behavior, and t is a power law exponent in the range of 1-1.33.

**10.** A method according to any of the preceding claims, wherein the solution processed graphene used to form the layer of solution processed graphene (6) comprises a plurality of individual sheets of graphene stabilized in a liquid.

**11.** A method according to claim 10, wherein:

at least a majority of the individual sheets have a longest dimension in the range of 1 nanometre to 100 micrometre, optionally in the range of 20 nanometres to 50 micrometres; and/or the layer of solution processed graphene (6) is formed from a non-percolative distribution of the individual sheets.

**12.** A method according to any of the preceding claims, further comprising:

applying a heat treatment to the composite layer to cause sintering of the metal nanowires.

**13.** An apparatus for manufacturing a conductive thin film, comprising:

a metal nanowire forming assembly; and a solution processed graphene forming assembly, the metal nanowire forming assembly and the solution processed graphene assembly being configured to form a composite layer on a substrate, the composite layer comprising a layer of solution processed graphene (6) directly adjacent to a layer of metal nanowires (4), **characterised in that** the apparatus is configured so that the forming of the layer of graphene (6) comprises spraying of the graphene onto a surface on which the layer is to be formed.

**14.** A method or apparatus according to any of the preceding claims, wherein the substrate (2) is transparent.

**15.** A touch screen panel, photovoltaic panel, battery or fuel cell comprising a conductive thin film produced according to the method of any of claims 1-12.

**Patentansprüche**

**1.** Verfahren des Herstellens eines leitenden Dünnfilms, umfassend:

Bilden einer Verbundschicht auf einem Substrat (2), wobei die Verbundschicht eine Schicht aus lösungsverarbeitetem Graphen (6) umfasst, die direkt an eine Schicht aus metallischen Nanodrähten (4) angrenzt, **dadurch gekennzeichnet, dass**:

das Bilden der Schicht aus Graphen (6) ein Sprühen des Graphens auf eine Oberfläche umfasst, auf der die Schicht gebildet werden soll.

**2.** Verfahren nach Anspruch 1, wobei die Schicht aus metallischen Nanodrähten (4) eine Monoschicht ist.

**3.** Verfahren nach Anspruch 1 oder 2, wobei die Verbundschicht eine Durchlässigkeit für sichtbares Licht von mindestens 40 % aufweist.

**4.** Verfahren nach einem der vorstehenden Ansprüche, wobei die Schicht aus metallischen Nanodrähten (4) vor der Schicht aus lösungsverarbeitetem Graphen (6) auf dem Substrat (2) gebildet ist und das Verfahren ein Anwenden einer Wärmebehandlung auf die Schicht aus metallischen Nanodrähten (4), um ein Sintern zwischen den metallischen Nanodrähten zu bewirken, vor der Bildung der Schicht aus lösungsverarbeitetem Graphen (6) umfasst.

5. Verfahren nach einem der Ansprüche 1-3, wobei die Schicht aus lösungsverarbeitetem Graphen (6) vor der Schicht aus metallischen Nanodrähten (4) auf dem Substrat (2) gebildet ist.

6. Verfahren nach Anspruch 5, ferner umfassend:

Anwenden einer Wärmebehandlung auf die Schicht aus metallischen Nanodrähten (4), um ein Sintern zwischen den metallischen Nanodrähten zu bewirken, nach der Bildung der Schicht aus metallischen Nanodrähten (4).

7. Verfahren nach Anspruch 5, wobei das Substrat (2) mit einer Oberflächenmikrostruktur bereitgestellt ist, die wirksam ist, um Lagen des lösungsverarbeiteten Graphens in die Schicht aus metallischen Nanodrähten (4) zu pressen, um ein Wickeln der Lagen um Verbindungen zwischen verschiedenen Nanodrähten zu bewirken.

8. Verfahren nach Anspruch 7, wobei die Mikrostruktur eine charakteristische Längenskala aufweist, die innerhalb eines Faktors von 10 der durchschnittlichen Trennung zwischen Verbindungen zwischen verschiedenen Drähten liegt.

9. Verfahren nach einem der vorstehenden Ansprüche, wobei die metallische Nanodrahtschicht (4) bei einer Dichte abgeschieden wird, die die optischen und/oder elektrischen Eigenschaften des Films dazu veranlasst, ein perkolatives Verhalten in einem größeren Ausmaß als ein Schüttverhalten zu zeigen, wobei ein perkolatives Verhalten durch Erfüllung des folgenden Potenzgesetzes gekennzeichnet ist:

$$\sigma = \sigma_0 \, (\phi\text{-}\phi_c)^t \text{ für } \phi > \phi_c$$

wobei $\sigma$ die Leitfähigkeit der Nanodrahtschicht (S/cm) ist, $\sigma_0$ eine Proportionalitätskonstante ist und $\phi$ die Konzentration von Nanodrähten in der Schicht ist, $\phi_c$ die kritische Konzentration ist, die die Untergrenze des perkolativen Verhaltens markiert, und t ein Exponent des Potenzgesetzes in dem Bereich von 1-1,33 ist.

10. Verfahren nach einem der vorstehenden Ansprüche, wobei das lösungsverarbeitete Graphen, das verwendet wird, um die Schicht aus lösungsverarbeitetem Graphen (6) zu bilden, eine Vielzahl von einzelnen Lagen aus Graphen, die in einer Flüssigkeit stabilisiert sind, umfasst.

11. Verfahren nach Anspruch 10, wobei:

mindestens eine Mehrheit der einzelnen Lagen eine längste Abmessung in dem Bereich von 1 Nanometer bis 100 Mikrometern, optional in dem Bereich von 20 Nanometern bis 50 Mikrometern aufweisen; und/oder die Schicht aus lösungsverarbeitetem Graphen (6) aus einer nicht-perkolativen Verteilung der einzelnen Lagen gebildet ist.

12. Verfahren nach einem der vorstehenden Ansprüche, das ferner Folgendes umfasst:

Anwenden einer Wärmebehandlung auf die Verbundschicht, um ein Sintern der metallischen Nanodrähte zu bewirken.

13. Vorrichtung zum Herstellen eines leitenden Dünnfilms, umfassend:

eine metallische Nanodraht-Formanordnung; und eine lösungsverarbeitete Graphen-Formanordnung, wobei die metallische Nanodraht-Formanordnung und die lösungsverarbeitete Graphen-Formanordnung konfiguriert sind, um eine Verbundschicht auf einem Substrat zu bilden, wobei die Verbundschicht eine Schicht aus lösungsverarbeitetem Graphen (6) umfasst, die direkt an eine Schicht aus metallischen Nanodrähten (4) angrenzt, **dadurch gekennzeichnet, dass** die Vorrichtung konfiguriert ist, sodass das Bilden der Schicht aus Graphen (6) ein Sprühen des Graphens auf eine Oberfläche umfasst, auf der die Schicht gebildet werden soll.

14. Verfahren oder Vorrichtung nach einem der vorstehenden Ansprüche, wobei das Substrat (2) transparent ist.

15. Berührungsempfindlicher Bildschirm, Fotovoltaik-Paneel, Batterie oder Brennstoffzelle, umfassend einen leitenden Dünnfilm, der gemäß dem Verfahren nach einem der Ansprüche 1-12 hergestellt ist.

**Revendications**

1. Procédé de fabrication d'un film mince conducteur, comprenant :

la formation d'une couche composite sur un substrat (2), la couche composite comprenant une couche de graphène traité en solution (6) directement adjacente à une couche de nanofils métalliques (4), **caractérisé en ce que** :

la formation de la couche de graphène (6) comprend la pulvérisation du graphène sur une surface sur laquelle la couche doit être formée.

2. Procédé selon la revendication 1, dans lequel la couche de nanofils métalliques (4) est une monocouche.

3. Procédé selon la revendication 1 ou 2, dans lequel la couche composite présente une transmission de lumière visible d'au moins 40 %.

4. Procédé selon l'une quelconque des revendications précédentes, dans lequel la couche de nanofils métalliques (4) est formée sur un substrat (2) avant la couche de graphène traité en solution (6), et le procédé comprend l'application d'un traitement thermique à la couche de nanofils métalliques (4) pour entraîner le frittage entre les nanofils métalliques (4), avant la formation de la couche de graphène traité en solution (6).

5. Procédé selon l'une quelconque des revendications 1 à 3, dans lequel la couche de graphène traité en solution (6) est formée sur le substrat (2) avant la couche de nanofils métalliques (4).

6. Procédé selon la revendication 5, comprenant en outre :

l'application d'un traitement thermique à la couche de nanofils métalliques (4) pour entraîner le frittage entre les nanofils métalliques, après la formation de la couche de nanofils métalliques (4).

7. Procédé selon la revendication 5, dans lequel le substrat (2) est doté d'une microstructure de surface qui est efficace pour presser des feuilles du graphène traité en solution dans la couche de nanofils métalliques (4) afin d'entraîner l'enroulement des feuilles autour de jonctions entre différents nanofils.

8. Procédé selon la revendication 7, dans lequel la microstructure présente une échelle de longueur caractéristique qui n'est pas supérieure à un facteur de 10 de la séparation moyenne entre des jonctions entre différents fils.

9. Procédé selon l'une quelconque des revendications précédentes, dans lequel la couche de nanofils métalliques (4) est déposée selon une densité qui entraîne les propriétés optiques et/ou électriques du film à présenter un comportement de percolation dans une plus grande mesure qu'un comportement en masse, le comportement de percolation étant **caractérisé par** la vérification de la loi exponentielle suivante :

$$\sigma = \sigma_0 \left(\phi - \phi_c\right)^t \text{ pour } \phi > \phi_c$$

où $\sigma$ représente la conductivité de la couche de nanofils (S/cm), $\sigma_0$ représentant une constante de proportionnalité, et $\phi$ représentant la concentration de nanofils dans la couche, $\phi_c$ représentant la concentration critique marquant la limite inférieure du comportement de percolation et t étant un exposant de la loi exponentielle situé dans la plage de 1 à 1,33.

10. Procédé selon l'une quelconque des revendications précédentes, dans lequel le graphène traité en solution utilisé pour former la couche de graphène traité en solution (6) comprend une pluralité de feuilles individuelles de graphène stabilisé dans un liquide.

11. Procédé selon la revendication 10, dans lequel :

au moins une majorité des feuilles individuelles présentent une plus grande dimension dans la plage de 1 nanomètre à 100 micromètres, éventuellement dans la plage de 20 nanomètres à 50 micromètres ; et/ou
la couche de graphène traité en solution (6) est formée à partir de la répartition de non percolation des feuilles individuelles.

12. Procédé selon l'une quelconque des revendications précédentes, comprenant en outre l'application d'un traitement thermique à la couche composite pour entraîner le filtrage des nanofils métalliques.

13. Appareil de fabrication d'un film mince conducteur, comprenant :

un ensemble de formation de nanofils métalliques ; et
un ensemble de formation de graphène traité en solution,
l'ensemble de formation de nanofils métalliques et l'ensemble de graphène traité en solution étant conçus pour former une couche composite sur un substrat, la couche composite comprenant une couche de graphène traité en solution (6) directement adjacente à une couche de nanofils métalliques (4), **caractérisé en ce que** l'appareil est conçu de manière que la formation de la couche de graphène (6) comprend la pulvérisation du graphène sur une surface sur laquelle la couche doit être formée.

14. Procédé ou appareil selon l'une quelconque des revendications précédentes, dans lequel le substrat (2) est transparent.

15. Panneau à écran tactile, panneau photovoltaïque, pile électrique ou à combustible comprenant un film fin conducteur produit selon le procédé de l'une quelconque des revendications 1 à 12.

Fig. 1

Fig. 2

Fig. 3

Fig. 4

Fig. 5

Fig. 6

Fig. 7

Fig. 8

## Fig. 9

## Fig. 10

Fig. 11

Fig. 12

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2013255763 A1
- US 20120070612 A1

### Non-patent literature cited in the description

- **VAN DE GROEP, J. ; P. SPINELLI ; A. POLMAN.** Transparent Conducting Silver Nanowire Networks. *Nano Letters,* 2012, vol. 12 (6), 3138-3144
- **HU, L. et al.** Scalable Coating and Properties of Transparent, Flexible, Silver Nanowire Electrodes. *ACS Nano,* 2010, vol. 4, 2955-2963
- **SCARDACI, V. et al.** Spray Deposition of Highly Transparent, Low-Resistance Networks of Silver Nanowires over Large Areas. *Small,* 2011, vol. 7 (18), 2621-2628
- **SCARDACI, V. ; R. COULL ; J.N. COLEMAN.** Spray deposition of Silver Nanowire transparent conductive networks. *Nanotechnology (IEEE-NANO), 2012 12th IEEE Conference on,* 2012
- **YUN, Y.S. et al.** Transparent conducting films based on graphene oxide/silver nanowire hybrids with high flexibility. *Synthetic Metals,* 2012, vol. 162 (15-16), 1364-1368
- **XINFENG, Z. ; W.N.M. WONG ; M.M.F. YUEN.** Conductive, transparent, flexible electrode from silver nanowire thin film with double layer structure. *Nanotechnology (IEEE-NANO), 2012 12th IEEE Conference on,* 2012
- **KHOLMANOV, I.N. et al.** Improved Electrical Conductivity of Graphene Films Integrated with Metal Nanowires. *Nano Letters,* 2012, vol. 12 (11), 5679-5683
- **AHN, Y ; Y. JEONG ; Y. LEE.** Improved Thermal Oxidation Stability of Solution-Processable Silver Nanowire Transparent Electrode by Reduced Graphene Oxide. *ACS Applied Materials & Interfaces,* 2012, vol. 4 (12), 6410-6414
- **CHEN, R. et al.** Co-Percolating Graphene-Wrapped Silver Nanowire Network for High Performance, Highly Stable, Transparent Conducting Electrodes. *Advanced Functional Materials,* 2013
- **STAUFFER, D.** Introduction to percolation theory. Taylor & Francis, 1985
- **KULSHRESHTHA, A. K. ; VASILE, C.** Handbook of polymer blends and composites. Rapra Technology Lt, 2002
- **FAHIMI et al.** *Carbon,* 2013
- **LEE, J. et al.** Solution-processed metal nanowire mesh transparent electrodes. *Nano Lett,* 2008, vol. 8, 689-692